(19) Europäisches Patentamt
European Patent Office
Office européen des brevets

(11) Publication number: 0 295 626 A2

# (12) EUROPEAN PATENT APPLICATION

(21) Application number: 88109468.4

(51) Int. Cl.⁴: **G03F 7/08**

(22) Date of filing: **14.06.88**

(30) Priority: **15.06.87 JP 147066/87**

(43) Date of publication of application: **21.12.88 Bulletin 88/51**

(84) Designated Contracting States: **DE NL**

(71) Applicant: **HITACHI, LTD.**
**6, Kanda Surugadai 4-chome Chiyoda-ku**
**Tokyo 100(JP)**

Applicant: **Hitachi Chemical Co., Ltd.**
**1-1, Nishi-shinjuku 2-chome Shinjuku-ku**
**Tokyo 160(JP)**

(72) Inventor: **Tanaka, Toshihiko**
**6-26-14, Kinuta**
**Setagaya-ku Tokyo(JP)**
Inventor: **Hashimoto, Michiaki**
**1611-57, Irumagawa**
**Sayama-shi Saitama-ken(JP)**
Inventor: **Koibuchi, Shigeru**
**1-16-15-2, Takasuzu-cho**
**Hitachi-shi Ibaraki-ken(JP)**
Inventor: **Fukuda, Hiroshi**
**4-14-6, Nishikoigakubo**
**Kokubunji-shi Tokyo(JP)**
Inventor: **Hasegawa, Norio**
**2196-173, Hirai Hinode-machi**
**Nishitama-gun Tokyo(JP)**

(74) Representative: **Strehl, Schübel-Hopf, Groening, Schulz**
**Widenmayerstrasse 17 Postfach 22 03 45**
**D-8000 München 22(DE)**

## (54) Photosensitive composition.

(57) A photoresist pattern exhibiting high resolution for an i-line exposure and having a steep sectional profile can be formed by making use of a photosensitive composition comprising a cresol novolac resin and a sensitizer blended therewith wherein(i) the cresol novolac resin has a meta to para ratio of 50/50 to 70/30 and a standard polystyrene equivalent weight-average molecular weight of 5,000 to 50,000 and(ii) the sensitizer comprises an ester of 1-oxo-2-diazonaphthoquinone-5-sulfonic acid with 2,3,4-trihydroxybenzophenone and/or an ester of 1-oxo-2-diazonaphthoquinone-5-sulfonic acid with 2,3,4,4′-tetrahydroxybenzophenone and the content of said sensitizer is 14 to 35 % by weight based on said polymer compound.

EP 0 295 626 A2

# PHOTOSENSITIVE COMPOSITION

## Background of the Invention

The present invention relates to a photosensitive composition sensitive to an ultraviolet radiation and particularly to a photosensitive composition especially suitable for an i-line exposure (wavelength: 365 nm).

In order to realize improvements in both the integration density and various performances of an LSI, such as an increase in the operating speed, it is necessary to enhance the fineness in the fabrication of wiring, electrodes, etc. At the present time, reduction projection printing is mainly used for the formation of a fine pattern in various semiconductor integrated circuits and magnetic bubble devices. The resolution in the reduction projection printing mainly depends upon the numerical aperture (NA) of an optical lense used, the wavelength of the light for exposure, λ, and the resolution of the photoresist.

In general, the resolving power, R, of a projection lens can be expressed by the following Rayleigh's equation:

$$R = 0.61 \frac{\lambda}{NA} \qquad (1)$$

Therefore, the use of the light for exposure having a small wavelength, λ, in the exposure is effective in improving the resolution, i.e., the resolving power, R.

In the formation of LSI, a substrate on which patterns of various wirings etc. are to be formed has a difference in level of usually 1 to 2 µm, and an exposure device has a field curvature of about 1 µm (which brings about a difference of about 1 µm in the position of the focus within the exposed surface). This requires a range of the depth of focus of about 2 to 3 µm or more for the formation of a fine pattern on the surface of a substrate having such a difference in level. Therefore, the depth of focus is a very important factor for the formation of a fine pattern.

The depth of focus, W, is represented by the following equation:

$$W = \pm \frac{\lambda}{2\ (NA)^2} \qquad \text{.....} \ (2)$$

Therefore, as can be seen from the equation (2), an increase in the value of numerical aperture, NA, for the purpose of improving the resolution unfavorably causes the depth of focus, W, to be decreased in reverse proportion to the value of the numerical aperture, NA, to the second power. On the other hand, when the wavelength, λ, of the light for exposure is decreased, the depth of focus, W, is decreased in proportion to the value of λ. For example, when the wavelength of the light and the NA of the lens are those commonly employed at the present time, i.e., 0.436 µm and 0.42, respectively, the depth of focus, W, is about ±1.2 µm, that is, the range in which an image can substantially be formed (hereinafter referred to an the "range of the depth of focus") is about 2.4 µm. This value is one substantially equal to or less than the desired range of the depth of focus. Therefore, a decrease in the wavelength of the light is effective when the depth of focus is taken into consideration.

For this reason, a proposal has been made on a stepper in which an i-line of a mercury lamp having a shorter wavelength (365 nm) than that (436 nm) of a g-line of a mercury lamp is used.

Meanwhile, with respect to a photoresist, it has become possible to use a photoresist having a high resolution because a photoresist having a high γ value, e.g., TSMR8800 (a trade name of a product of Tokyo Ohka Kogyo Co., Ltd.), has become commercially available. However, this photoresist is one to be used for a g-line exposure, and studies conducted by the present inventors have revealed that such a photoresist exhibits no satisfactory resolution in an i-line exposure. Further, the photoresist had a drawback that the formed photoresist pattern had no steep sectional profile but a smooth mountainlike shape and is therefore unfavorable from the standpoint of the change in the fabrication shape and size during etching.

Description about the i-line exposure is given in Technical Report of the Institute of Electronics, Information and Communication Engineers, SSD82-93, 1-8(1982). Further, conventional photoresists are described in, e.g., Japanese Patent Laid-Open No. 17112/1983, and the abovementioned photoresist TSMR8800 having a high γ value is described in the Catalog for Industrial Products of Tokyo Ohka Kogyo Co., Ltd., 33-35(1986).

As described above, conventional photoresists had problems such as insufficient resolution in an i-line exposure and an unsatisfactory profile of the formed photoresist pattern.

## Summary of the Invention

An object of the present invention is to provide a photosensitive composition which can solve the above-described problems of the prior art and exhibits a sufficient sensitivity to an i-line, a high resolution, and an excellent sectional profile after development.

Studies conducted by the present inventors have revealed that a material having a low content of an exposure independent absorption element (which is an element capable of absorbing light independent of the quantity of incident light and also known as the "non-bleaching photoabsorption element") and exhibiting a large change in the developing rate with a change in the concentration of an inhibitor (a development inhibitor) is useful for an improvement in the resolution and an increase in the steepness of the sectional profile.

Therefore, the above-described object of the present invention can be attained by decreasing the content of the non-bleaching photoabsorption element in a photoresist and using a resin, a sensitizer, and a sensitizer concentration each causing a rapid change in the developing rate with a change in the concentration of an inhibitor.

Specifically, the photosensitive composition of the present invention comprises a base resin composed of a cresol novolac resin having a meta to para ratio of 50/50 to 70/30 and, added thereto, a sensitizer composed of an ester of 1-oxo-2-diazona phthoquinone-5-sulfonic acid with 2,3,4-trihydroxybenzophenone or an ester of 1-oxo-2-diazonaphthoquinone-5-sulfonic acid with 2,3,4,4′-tetrahydroxybenzophenone or a mixture of these two esters (there is no particular limitation with respect to the mixing ratio).

The above-described photosensitive composition of the present invention exhibits an absorbance of about 0.1 $\mu m^{-1}$ after bleaching (i.e., a phenomenon in which the transmittance of a film increases with an increase in the quantity of incident light) with an i-line (wavelength: 365 nm). This value is close to the absorbance for a g-line of a photoresist usually employed for a g-line and about 1/2 to 1/4 of the absorbance for an i-line of a photoresist for a g-line. The reason why the photosensitive composition of the present invention exhibits a small absorbance after bleaching resides in a decrease in the content of the non-bleaching photoabsorption element.

Since the photosensitive composition of the present invention exhibits a small absorbance after bleaching with an i-line, the light reaches the bottom of the photoresist without significant attenuation even when an i-line is used as the light for exposure, which contributes to not only an improvement in the resolution but also an increase in the steepness of the sectional profile of the photoresist pattern.

The reasons why the meta to para ratio of the cresol novolac resin should be 50/50 to 70/30 are as follows. When the ratio is less than 50/50, the absorbance is increased, which brings about a lowering in the resolution. On the other hand, when the ratio exceeds 70/30, there occurs an excessive dissolution during development, which brings about a lowering in the resolution. These cases are both unfavorable.

Further, the use of a cresol novolac resin having a standard polystyrene equivalent weight-average molecular weight of 5,000 to 50,000 offers a balance between the heat resistance and the dissolution property during development of a photoresist pattern, which makes it possible to form a very excellent photoresist pattern. When the weight-average molecular weight is less than 5,000, the softening point of the cresol novolac resin is so low that the heat resistance is poor. On the other hand, when it exceeds 50,000, the dissolution property is poor. These cases are both unfavorable.

Further, it has been found that when the degree of esterification of the sensitizer and the concentration of the sensitizer based on the amount of the cresol novolac resin are at least 37.5 % and at least 14 % by weight, respectively, the development rapidly proceeds when the inhibitor concentration exceeds a certain critical inhibitor concentration, i.e., the $\gamma$ value is increased, which contributes to a remarkable improvement in the resolution. Hereinafter, the concentration of the sensitizer will be expressed in % by weight based on the amount of the cresol novolac resin.

The term "degree of esterification" is intended to mean the ratio of the amount of the ester linkage after the reaction to the amount of the hydroxy group of hydroxybenzophenone before the reaction.

It is preferable that the degree of esterification of the sensitizer be as high as possible, particularly at least 37.5 %, because a higher $\gamma$ value can be attained thereby. However, a sensitizer having a degree of esterification of less than 37.5 % may also be used. The degree of esterification can be increased by conducting the reaction in an increased ratio of diazonaphthoquinone-sulfonic acid to hydroxybenzophenone.

The concentration of the sensitizer is preferably as high as possible, provided that the concentration is at least 14 % by weight, because a property with respect to rapid progress of development is enhanced. This property depends upon the development system, and the concentration of the sensitizer is preferably at least 19 % by weight when spray development is used. From the viewpoint of the resolution, the most suitable concentration of the sensitizer is at least 27 % by weight. However, when the concentration exceeds 35 % by weight, the sensitizer precipitates due to occurrence of supersaturation. Therefore, the upper limit of the concentration is 35 % by weight.

## Brief Description of the Drawings

Fig. 1 is a graph showing the relationship between the concentration of a sensitizer in a photosensitive composition and the photoresist side wall taper angle after exposure and development of an example of the present invention;

Fig. 2 is a graph showing the relationship between the designed size of a pattern of a photosensitive composition and the deviation of the pattern from the designed size after exposure and development of an example of the present invention and a conventional example; and

Fig. 3 is a graph showing the relationship between the concentration of a sensitizer in a photosensitive composition and the photoresist side wall taper angle after exposure and development of another example of the present invention.

## Description of the Preferred Embodiments

### Example 1

A photoresist was prepared by making use of a cresol novolac resin having a meta to para ratio of 60/40 as a base resin and an ester of 1-oxo-2-diazonaphthoquinone-5-sulfonic acid with 2,3,4-trihydroxybenzophenone as a sensitizer. ECA (2-ethoxyethyl acetate) was used as a solvent. As described above, when the standard polystyrene equivalent weight average molecular weight of the cresol novolac resin was less than 5,000, the softening point of the cresol novolac resin was so low that the heat resistance was poor, while when it exceeded 50,000, the dissolution property was poor. Therefore, in this example, a cresol novolac resin having a weight-average molecular weight of 10,000 and a dispersion ($M_w/M_n$) of 7 was used. Herein, $M_w$ and $M_n$ mean a weight-average molecular weight and a number-average molecular weight, respectively.

The degree of esterification of the sensitizer was 94 % for triester, 5 % for diester, 1 % for monoester, and 97.7 % on the whole.

The above-described photoresists having a sensitizer concentration ranging from 10 to 50 % by weight were prepared to evaluate their properties. When the concentration of the sensitizer exceeded 35 % by weight, as described above, the sensitizer precipitated due to occurrence of supersaturation, which made it impossible to use the product as a photoresist. The absorbance of this photoresist for an i-line after an i-line exposure, i.e., after bleaching, was about 0.1 $\mu m^{-1}$ when the concentration of the sensitizer was 10 to 35 % by weight. This value was substantially equal to the value for a g-line of the conventional photoresist material for a g-line and about 1/2 to 1/3 of the absorbance for an i-line of the conventional photoresist for a g-line. For example, the absorbance of MP1300 (a trade name of a product of Shipley Co., Ltd.) was 0.363 $\mu m^{-1}$ for an i-line, while the absorbance of TSMR8800 (a trade name of a product of Tokyo Ohka Kogyo Co., Ltd.) was 0.271 $\mu m^{-1}$.

These photoresists were applied on a Si substrate in a thickness of 1 $\mu$m and heat treated. The heat treatment was conducted in a vacuum chuck hot plate oven at 100°C for 1 min. Then, an exposure was conducted with a pattern of 0.6 $\mu$m line and space (i.e., a pattern in which lines having a width of 0.6 $\mu$m are spaced at equal intervals of 0.6 $\mu$m) using an i-line exposure stepper having an NA of 0.42. After the exposure, the photoresist was subjected to puddle development for 30 sec. with an aqueous 40 % MF 312 (a trade name of a product of Shipley Co., Ltd.) solution to form a pattern. The profiles of the photoresists were compared with each other in such an exposure dose as will make the line width equal to the space width. As a result, it was found that the steepness of the sectional profile of the photoresist was icnreased with an increase in the concentration of the sensitizer. The steepness was evaluated in terms of a side wall taper angle at the bottom of the photoresist in contact with the surface of the substrate (i.e., a tapering angle at the bottom of the photoresist layer). The results are shown in Fig. 1, wherein curve 1 shows the dependence of the side wall taper angle on the concentration of the sensitizer of the photosensitive composition in this example. When the concentration of the sensitizer was 14 % by weight or less, the taper angle was small, and the section of the photoresist had a smooth mountainlike shape. On the other hand, as shown in curve 1, when the concentration of the sensitizer exceeded 14 % by weight, the taper angle was increased to 81° or more, i.e., a pattern having sufficient steepness was formed. It is noted that the taper angle of TSMR8800 (a trade name of a product of Tokyo Ohka Kogyo Co., Ltd.) known as a conventional photoresist exhibiting a high resolution was 79° after an i-line exposure and developement. Therefore, it is apparent that the use of the photosensitive composition of the present invention enables the formation of a photoresist pattern with a sectional profile having steepness larger than that attained by the conventional photoresist through an i-line exposure. Further, when the concentration of the sensitizer exceeded 27 % by weight, the photoresist pattern was free from the rounding at the top thereof, and an excellent profile could be formed. Thereafter, the photoresist pattern was transferred on a Si substrate. The use of a photoresist having a larger taper angle caused a smaller degree of the pattern width change during etching and enabled fabrication of a pattern having a more steep sectional profile, i.e., brought about a large effect. The term "pattern width change during etching" used herein is intended to mean the difference in size between the photoresist pattern before the etching and the pattern formed on a fabricating film after the etching.

Thereafter, the resolution of the photoresist was determined. The threshold resolution was defined as the "size of a pattern enabling resolution" and the "minimum size in which the deviation from the designed size falls within ±0.1 µm" when an exposure was conducted at an exposure dose capable of forming a striped photoresist pattern exactly having a line width of 0.6 µm and a space width of 0.6 µm.

An example of the results is shown in Fig. 2. As can be seen from curve 2 showing the resolution property in the case where the concentration of the sensitizer was 28 % by weight, the minimum resolving size in which the deviation from the designed size falls within ±0.1 µm was about 0.4 µm.

As can be seen from Fig. 2, when an i-line exposure was conducted by making use of the conventional photoresist (TSMR8800; a product of Tokyo Ohka Kogyo Co., Ltd.), the minimum resolving size was about 0.51 µm as shown in curve 3, and the photoresist of the present invention having a sensitizer concentration of 28 % by weight exhibited a resolution higher than that of the conventional photoresist by about 20 %. Further, with respect to the minimum size enabling resolution as well, the present invention having a sensitizer concentration of 28 % by weight exhibited a value of about 0.38 µm, i.e., exhibited a 20 % improvement over the value of the conventional photoresist, i.e., about 0.49 µm.

Then, the relationship between the concentration of the sensitizer in the photoresist of the present invention and the minimum resolving size, i.e., the above-described size of pattern enabling resolution, was determined. The minimum resolving size was decreased to less than about 0.5 µm when the concentration of the sensitizer exceeded about 14 % by weight, further decreased with an increase in the concentration of the sensitizer, and reached a constant value, i.e., about 0.38 µm, when the concentration of the sensitizer exceeded about 27 % by weight. Thus, excellent resolution can be obtained when the concentration of the sensitizer exceeds about 14 % by weight, and the maximum resolution can be attained when the concentration of the sensitizer is at least about 27 % by weight.

In the present example, a description has been made with respect to the case where the meta to para ratio of the cresol novolac resin was 60/40. However, the meta to para ratio is not limtied to this value only, and similar excellent results could be obtained when the meta to para ratio was 50/50 to 70/30. A meta to para ratio of less than 45/55 brought about a lowering in the dissolution property. On the other hand, a meta to para ratio of higher than 80/20 brought about an excessive increase in the solubility. This in turn caused the unexposed portion as well to be removed during development. Further, as described above, a lowering in the meta to para ratio to less than 50/50 brought about a lowering in the resolution due to an increase in the absorbance, while a meta to para ratio exceeding 70/30 brought about a lowering in the resolution due to an excessive increase in the solubility during development.

Further, in this example, a description has been made with respect to the case where the degree of esterification of the sensitizer was 94 % for triester, 5 % for diester, and 1 % for monoester. However, the degree of esterification is not limited to this value only. In fact, a favorable effect could be attained when the average degree of esterification was 37.5 % or more. The resolution was increased with an increase in the degree of esterification.

Further, in this example, a description has been made with respect to the case where an ester of 1-oxo-2-diazonaphthoquinone-5-sulfonic acid with 2,3,4-trihydroxybenzophenone was used as the sensitizer. However, the sensitizer is not limited to this ester only. In fact, favorable results could be obtained when the sensitizer was an ester of 1-oxo-2-diazonaphthoquinone-5-sulfonic acid with 2,3,4,4′-tetrahydroxybenzophenone, a mixture of the above-described two esters, or an ester of gallic acid.

Example 2

The same photoresist as that of Example 1 was used to evaluate the profile of the photoresist. However, with respect to the development, a spray development was employed instead of the puddle development. The developer was the same as that of Example 1, i.e., an aqueous 40 % MF312 solution. The profile of the photoresist was evaluated in the same manner as that of Example 1, i.e., evaluated in terms of the side wall taper angle at the bottom of the photoresist. As can be seen from Fig. 3 showing the results, in the photoresist of the present invention, a taper angle of 83° or more was obtained when the concentration of the sensitizer was at least 19 % by weight. Therefore, in the case of the spray development, it is preferred that the concentration of the sensitizer be at least 19 % by weight. Curve 4 of Fig. 3 shows the dependence of the side wall taper angle upon the concentration of the sensitizer of the photosensitive composition in the present example.

It is noted that the conventional photoresist (TSMR8800) exhibited a taper angle of 74°.

As described above, the photosensitive composition or photoresist of the present invention exhibits high transmittance for an i-line (wavelength: 365 nm) and excellent developing properties, which enables the formation of a photoresist pattern having high resolution and a steep sectional profile.

For example, a striped photoresist pattern having a line width of 0.4 μm and a space width of 0.4 μm could be formed with an i-line lens having an NA of 0.42, and an about 20 % improvement in the resolution could be attained over the conventional photoresist.

**Claims**

1. A photosensitive composition comprising (i) a polymer compound consisting essentially of a cresol novolac resin having a meta to para ratio of 50/50 to 70/30 and a standard polystyrene equivalent weight-average molecular weight of 5,000 to 50,000 and(ii) a sensitizer consisting essentially of at least one ester selected from the group consisting of an ester of 1-oxo-2-diazonaphthoquinone-5-sulfonic acid with 2,3,4-trihydroxybenzophenone, an ester of 1-oxo-2-diazonaphthoquinone-5-sulfonic acid with 2,3,4,4′-tetrahydroxybenzophenone and an ester of gallic acid, the content of said sensitizer being 14 to 35 % by weight based on said polymer compound.

2. A photosensitive composition according to claim 1, wherein the content of said sensitizer is 19 to 35 % by weight.

3. A photosensitive composition according to claim 1, wherein the content of said sensitizer is 27 to 35 % by weight.

4. A photosensitive composition according to claim 1, wherein the content of said sensitizer is 19 to 32 % by weight.

5. A photo sensitive composition according to claim 1, wherein the content of said sensitizer is 27 to 32 % by weight.

6. A photosensitive composition according to claim 1, wherein the degree of esterification of said ester is at least 37.5 %.

FIG. 1

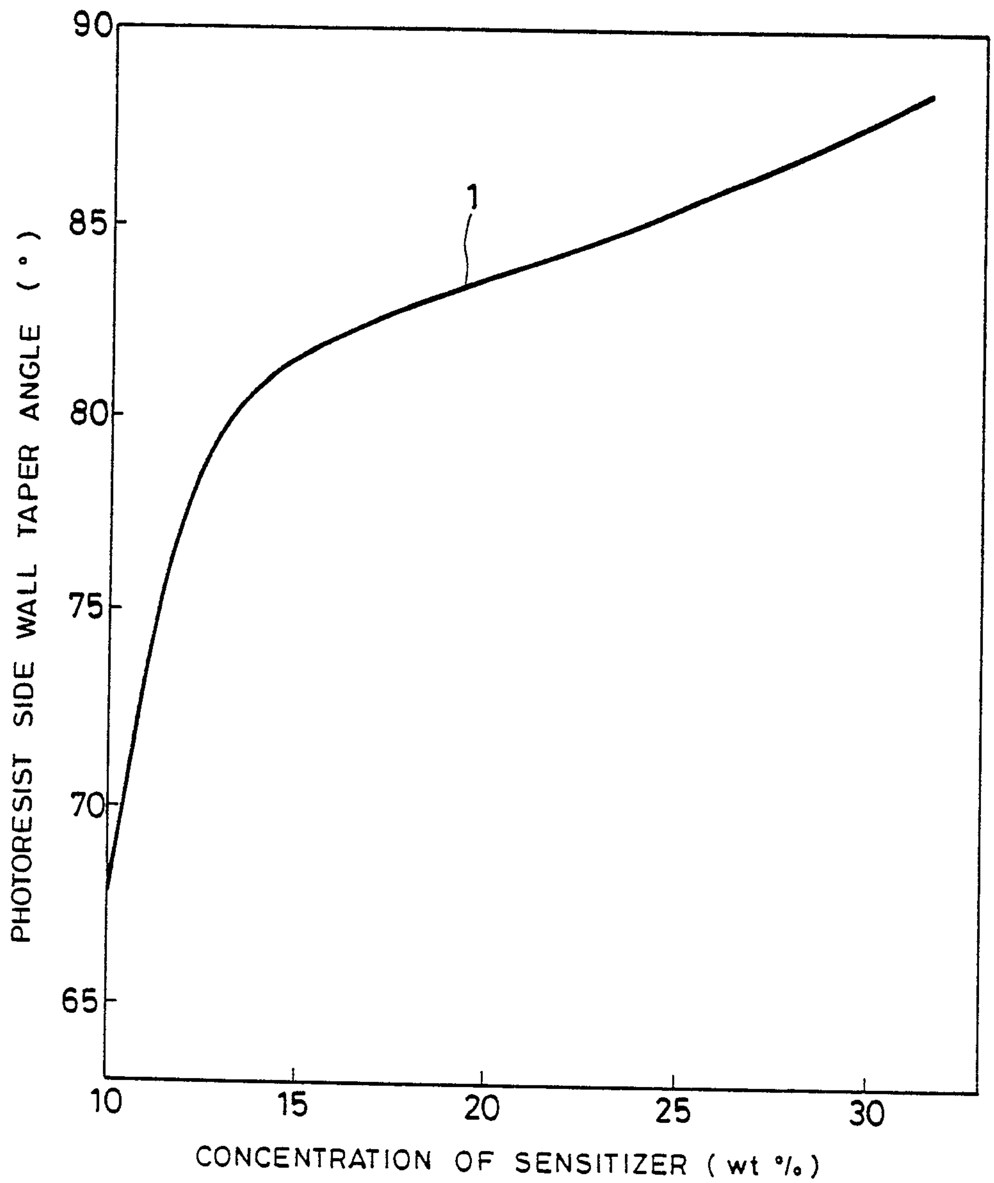
90
85
80
75
70
65
PHOTORESIST SIDE WALL TAPER ANGLE (°)
1
10
15
20
25
30
CONCENTRATION OF SENSITIZER (wt %)

FIG. 2

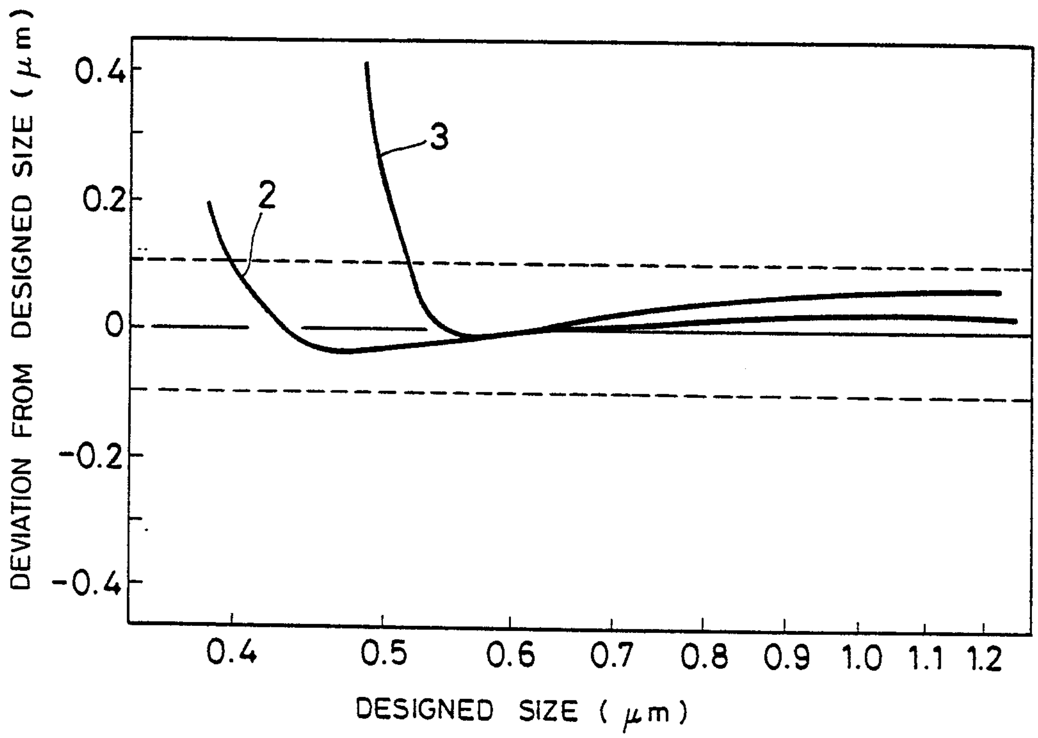
DEVIATION FROM DESIGNED SIZE ( μm )
0.4
0.2
0
-0.2
-0.4
3
2
0.4
0.5
0.6
0.7
0.8
0.9
1.0
1.1
1.2
DESIGNED SIZE ( μm )

FIG. 3

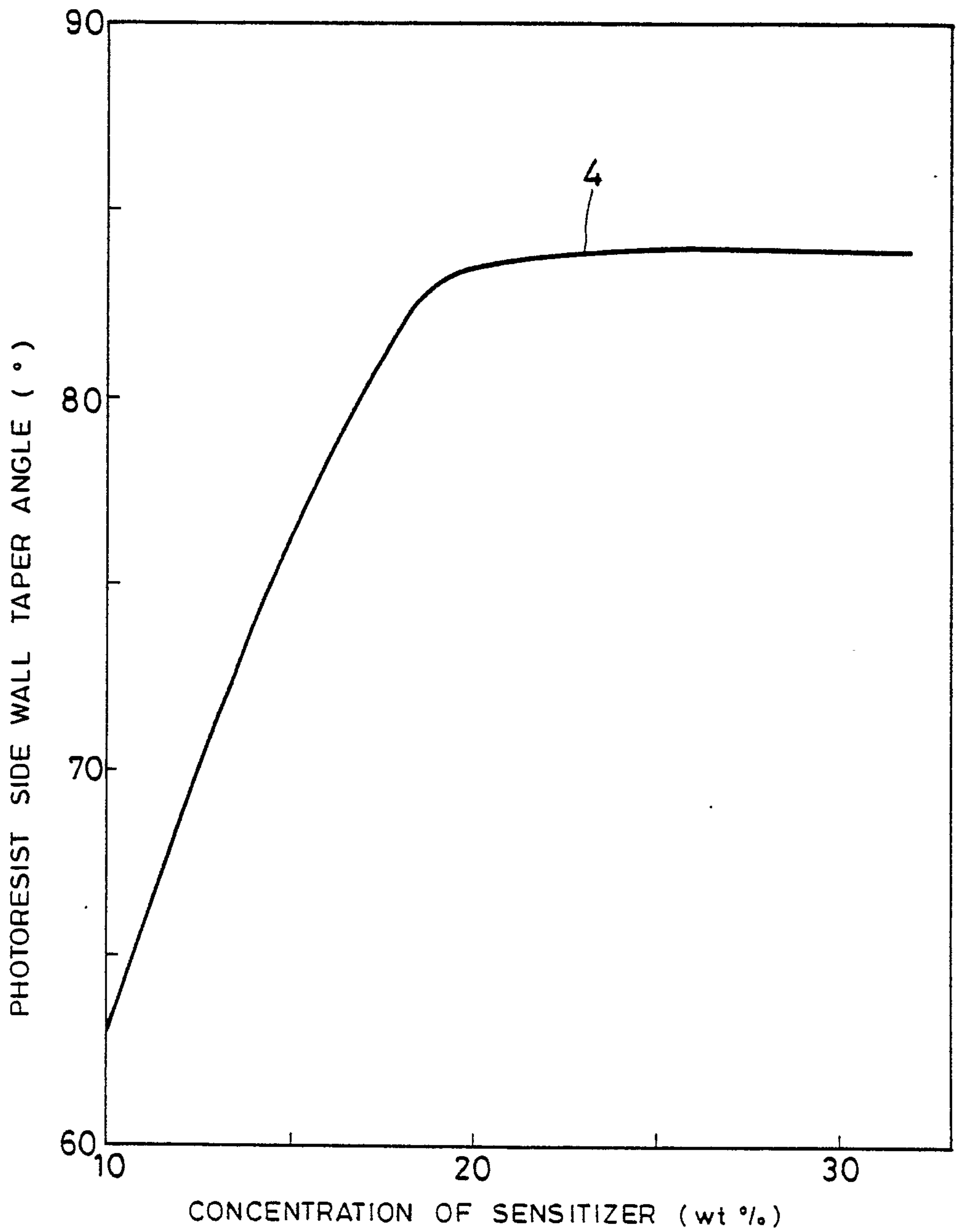
90
80
70
60
10
20
30
4
PHOTORESIST SIDE WALL TAPER ANGLE ( ° )
CONCENTRATION OF SENSITIZER (wt %)